# EUROPEAN PATENT APPLICATION

(11) **EP 1 926 111 A2**
(43) Date of publication of application: **28.05.2008**
(21) Application number: 07111517.4
(22) Date of filing: 02.07.2007
(51) Int. Cl.: H01G 9/20

(54) **Dye-sensitized solar cell module having vertically stacked cells and method of manufacturing the same**

(30) Priority: 21.11.2006 KR 20060115444
(71) Applicant: ELECTRONICS AND TELECOMMUNICATIONS RESEARCH INSTITUTE, Daejeon-shi (KR)
(72) Inventor: Kang, Mangu, Daejeon-city (KR); Oh, Soo Young, Daejeon-city (KR); Jun, Yongseok, Daejeon-city (KR); Kim, Jong Dae, Daejeon-city (KR)
(74) Representative: Betten & Resch

(57) **Abstract**

Provided are a dye-sensitized solar cell module having a vertically stacked cell structure and a method of manufacturing the same. In the dye-sensitized solar cell module, a plurality of cells are vertically stacked in parallel with each other. Each of the cells includes mutually facing semiconductor and counter electrodes and an electrolyte layer interposed between the semiconductor and counter electrodes. A first conductive transparent substrate is interposed between two neighboring cells of the cells. The first conductive transparent substrate includes a first surface on which the counter electrode of one of the two neighboring cells is formed and a second surface on which the semiconductor electrode of the other is formed. A second conductive transparent substrate having a semiconductor electrode forms the lowermost cell of the cells, and a third conductive transparent substrate having a counter electrode forms the uppermost cell of the cells.

## Description

### CROSS-REFERENCE TO RELATED PATENT APPLICATION

This application claims the benefit of Korean Patent Application No. 10-2006-0115444, filed on November 21, 2006, in the Korean Intellectual Property Office, the disclosure of which is incorporated herein in its entirety by reference.

### BACKGROUND OF THE INVENTION

### 1. Field of the Invention

The present invention relates to a solar cell module, and more particularly, to a dye-sensitized solar cell module having a vertically stacked cell structure.

### 2. Description of the Related Art

Solar cell technology, which is used for converting solar energy into electrical energy using semiconductors or the like, has become more important and much research is being conducted on solar cell technology due to regulations limiting the generation of carbon dioxide and the exhaustion and price increase of fossil fuels.

Unlike the conventional p-n junction silicon solar cells, dye-sensitized solar cells photo-electrochemically convert solar energy into electrical energy. For this, a dye-sensitized solar cell includes photosensitive dye molecules capable of generating electron-hole pairs by absorbing visible light and a transition metal oxide transmitting electrons.

Representative examples of dye-sensitized solar cells are disclosed in U.S. Patent Nos. 4,927,721 and 5,350,644, issued to Gratzel et al. (Switzerland). The disclosed dye-sensitized solar cells are photo-electrochemical solar cells that include a nanoparticle oxide semiconductor electrode, a Pt electrode, a dye formed on the nanoparticle oxide semiconductor electrode, and a redox electrolyte. Thus, dye molecules generate electron-hole pairs by absorbing visible light, and the nanoparticle oxide semiconductor electrode transfers generated electrons. Such disclosed dye-sensitized solar cells are considered as the next generation of solar cells for replacing the conventional silicon solar cells since the dye-sensitized solar cells are inexpensive as compared with the conventional silicon solar cells.

An open circuit voltage of a dye-sensitized solar cell is determined by the potential difference between the Fermi energy level of a nanoparticle oxide semiconductor electrode and the redox energy level of a redox electrolyte and conventionally, the open circuit voltage of a dye-sensitized solar cell ranges from 0.6 V to 1.0 V.

However, electronic devices such as MP3 players, portable phones, CD players, and electronic dictionaries require at least 1.5 V to operate. Therefore, for example, seven 0.6 V dye-sensitized solar cells are connected in series in order to be used as a 3.7 V power source of a portable phone.

Various conventional connection techniques have been introduced to connect a plurality of solar cells so as to provide required voltage levels, as disclosed in, for example, Korean Patent Laid-Open Publication No. 2004-34912. However, solar cell modules using the conventional connection techniques have a small effective area. Hence, only a small portion of the total area of the solar cell module is used for absorbing solar energy and generating electrical energy. Furthermore, a conductive layer that is formed on a substrate should be etched so as to electrically separate electrodes of the solar cells arrayed in the solar cell module, and the electrodes should be connected using connection lines through an additional process, and thus, further complicating the manufacturing processes of the solar cell module.

### SUMMARY OF THE INVENTION

The present invention provides a dye-sensitized solar cell module having a vertically stacked cell structure for efficiently converting solar energy into electrical energy by maximizing the effective area of solar cells.

The present invention also provides a simple and productive method of manufacturing a dye-sensitized solar cell module having a vertically stacked cell structure for maximizing the effective area of solar cells.

According to an aspect of the present invention, there is provided a dye-sensitized solar cell module with a vertically stacked cell structure. The dye-sensitized solar cell module includes a plurality of cells vertically stacked in parallel with each other, each of the cells including mutually facing semiconductor electrode and counter electrode and an electrolyte layer interposed between the semiconductor electrode and counter electrode. The dye-sensitized solar cell module further includes at least one of first conductive transparent substrate interposed between two neighboring first cell and second cell of the plurality of cells, and the first conductive transparent substrates include a first surface on which the counter electrode of the first cell is formed and a second surface on which the semiconductor electrode of the second cell is formed. The dye-sensitized solar cell further include a second conductive transparent substrate comprising a third surface on which the semiconductor electrode of the lowermost cell of the plurality of cells is formed; and a third conductive transparent substrate comprising a fourth surface on which the counter electrode of the uppermost cell of the plurality of cells is formed.

Each of the first conductive transparent substrates may further include: a transparent substrate; and first and second conductive layers formed on both sides of the transparent substrate. Each of the first conductive transparent substrates may be formed of a conductive high polymer.

Only one of the first conductive transparent substrate may be disposed between the second and third conductive transparent substrates. Alternatively, a plurality of first conductive transparent substrates may be disposed between the second and third conductive transparent substrates.

The second conductive transparent substrate may be formed of a transparent substrate having a conductive layer only on an upper or lower surface of the transparent substrate, and the third conductive transparent substrate is formed of a transparent substrate having a conductive layer only on an upper or lower surface of the transparent substrate. Alternatively, second and third conductive transparent substrates may be formed of a conductive polymer.

The cells may be connected in series or in parallel with each other.

The first conductive transparent substrate may further include a third conductive layer electrically connecting the first and second conductive layers, and the two neighboring cells may be connected in series by the third conductive layer. The third conductive layer may be formed on a sidewall of the first conductive transparent substrate.

According to another aspect of the present invention, there is provided a method of manufacturing a dye-sensitized solar cell module having a vertically stacked cell structure. In the method, a first conductive transparent substrate is formed, which includes a first surface on which a first counter electrode is formed and a second surface on which a first semiconductor electrode is formed. A second conductive transparent substrate is formed, which includes a third surface on which a second semiconductor electrode is formed. The first and second conductive transparent substrates are aligned with the first counter electrode facing the second semiconductor electrode and spaced by a first predetermined distance apart from the second semiconductor electrode. An electrolyte solution is injected between the first counter electrode and the second semiconductor electrode so as to form a first electrolyte layer.

The aligning of the first and second conductive transparent substrates may include forming a barrier wall between the first and second conductive transparent substrates so as to seal a space between the first counter electrode and the second semiconductor electrode.

The method may further include: forming a third conductive transparent substrate including a fourth surface on which a second counter electrode is formed; aligning the first and third conductive transparent substrates with the first semiconductor electrode facing the second counter electrode, the first semiconductor electrode spaced by a second predetermined distance apart from the second counter electrode; and injecting an electrolyte solution between the first semiconductor electrode and the second counter electrode so as to form a second electrolyte layer.

The aligning of the first and third conductive transparent substrates may include forming a barrier wall between the first and third conductive transparent substrates so as to seal a space between the first semiconductor electrode and the second counter electrode.

The method may further include: forming a plurality of first conductive transparent substrates; vertically aligning the first conductive transparent substrates, the first conductive transparent substrates being parallel with each other and spaced a predetermined distance apart from each other; and injecting an electrolyte solution between the first conductive transparent substrates so as to form electrolyte layers.

According to the present invention, the dye-sensitized solar cell module having a vertically stacked cell structure can have a maximized effective area for absorbing solar energy and generating electrical energy. Furthermore, the dye-sensitized solar cell module having the vertically stacked cell structure can be manufactured through a simple process. Moreover, a desired open circuit voltage of the dye-sensitized solar cell module can be easily obtained since the number of stacked solar cells can be simply adjusted. In addition, dye-sensitized solar cell modules having different open circuit voltages can be manufactured using a single process line. Hence, dye-sensitized solar cell modules having different open circuit voltages can be efficiently manufactured with fewer costs.

### BRIEF DESCRIPTION OF THE DRAWINGS

The above and other features and advantages of the present invention will become more apparent by describing in detail exemplary embodiments thereof with reference to the attached drawings in which:
FIG. 1 is a schematic cross-sectional view illustrating a dye-sensitized solar cell module having a vertically stacked cell structure according to an embodiment of the present invention;
FIG. 2 is a schematic cross-sectional view illustrating a dye-sensitized solar cell module having a vertically stacked cell structure according to another embodiment of the present invention;
FIG. 3 is a flowchart of a method of manufacturing a dye-sensitized solar cell module having a vertically stacked cell structure according to an embodiment of the present invention;
FIG. 4 is a flowchart of a method of manufacturing a dye-sensitized solar cell module having a vertically stacked cell structure according to another embodiment of the present invention;
FIG. 5 is a flowchart of a method of manufacturing a dye-sensitized solar cell module having a vertically stacked cell structure according to another embodiment of the present invention; and
FIG. 6 is a current density versus voltage (I-V) graph illustrating test results comparing energy conversion efficiency of a dye-sensitized solar cell module of the present invention with that of a comparison sample.

### DETAILED DESCRIPTION OF THE INVENTION

The present invention will now be described more fully with reference to the accompanying drawings, in which exemplary embodiments of the invention are shown.

The invention may, however, be embodied in many different forms and should not be construed as being limited to the embodiments set forth herein; rather, these embodiments are provided so that this disclosure will be thorough and complete, and will fully convey the concept of the invention to one skilled in the art. It will also be understood that when a layer is referred to as being "on" another layer or substrate, it can be directly on the other layer or substrate, or intervening layers may also be present. In the drawings, the thicknesses of layers and regions are exaggerated for clarity, and like reference numerals denote like elements.

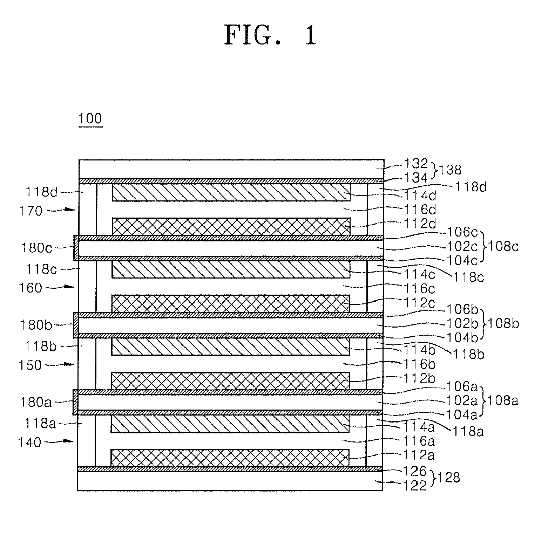

FIG. 1 is a schematic cross-sectional view illustrating a dye-sensitized solar cell module 100 having a vertically stacked cell structure according to an embodiment of the present invention.

Referring to FIG. 1, the dye-sensitized solar cell module 100 includes a plurality of cells 140, 150, 160 and 170 that are vertically arranged in parallel with one another. In the current embodiment, the dye-sensitized solar cell module 100 includes four cells 140, 150, 160, and 170, and the four cells 140, 150, 160, and 170 will now be denoted as first, second, third, and fourth cells, respectively. However, the present invention is not limited to this cell configuration. Hence, the dye-sensitized solar cell module 100 can include more solar cells than the ones shown. Therefore, although the following descriptions are made for the case where the dye-sensitized solar cell module 100 includes four cells, it is apparent to one of ordinary skill in the art that the descriptions can be applied to a dye-sensitized solar cell module including various numbers of cells.

The first, second, third, and fourth cells 140, 150, 160, and 170 respectively include semiconductor electrodes 112a, 112b, 112c, and 112d; counter electrodes 114a, 114b, 114c, and 114d; and electrolyte layers 116a, 116b, 116c, and 116d interposed between the semiconductor electrodes 112a, 112b, 112c, and 112d and the counter electrodes 114a, 114b, 114c, and 114d. The semiconductor electrodes 112a, 112b, 112c, and 112d respectively face the counter electrodes 114a, 114b, 114c, and 114d, respectively.

First conductive transparent substrates 108a, 108b, and 108c are interposed between the first and second cells 140 and 150, the second and third cells 150 and 160, and the third and fourth cells 160 and 170, respectively. The first conductive transparent substrates 108a, 108b, and 108c may include transparent substrates 102a, 102b, and 102c, respectively; first conductive layers 104a, 104b, and 104c formed on a side of the transparent substrates 102a, 102b, and 102c, respectively; and second conductive layers 106a, 106b, and 106c formed on the other side of the transparent substrates 102a, 102b, and 102c, respectively. The transparent substrates 102a, 102b, and 102c can be formed of glass. Each of the first and second conductive layers 104a, 104b, 104c, 106a, 106b, and 106c can be formed of an indium tin oxide (ITO), a fluorine-doped tin oxide (FTO), or SnO₂. However, the dye-sensitized solar cell module 100 of the present invention is not limited to the configuration of the first conductive transparent substrates 108a, 108b, and 108c illustrated in FIG. 1. Hence, the transparent substrates 102a, 102b, and 102c of the first conductive transparent substrates 108a, 108b, and 108c, respectively, can be conductive transparent substrates formed of a conductive high polymer. In this case, the first and second conductive layers 104a, 104b, 104c, 106a, 106b, and 106c may not be formed on both sides of the transparent substrates 102a, 102b, and 102c.

The counter electrode 114a of the first cell 140 is formed on the first conductive layer 104a of the first conductive transparent substrate 108a, and the semiconductor electrode 112b of the second cell 150 is formed on the second conductive layer 106a of the first conductive transparent substrate 108a. The counter electrode 114b of the second cell 150 is formed on the first conductive layer 104b of the first conductive transparent substrate 108b, and the semiconductor electrode 112c of the third cell 160 is formed on the second conductive layer 106b of the first conductive transparent substrate 108b. The counter electrode 114c of the third cell 160 is formed on the first conductive layer 104c of the first conductive transparent substrate 108c, and the semiconductor electrode 112d of the fourth cell 170 is formed on the second conductive layer 106c of the first conductive transparent substrate 108c.

A second conductive transparent substrate 128 is formed on a bottom surface of the dye-sensitized solar cell module 100, and a third conductive transparent substrate 138 is formed on a top surface of the dye-sensitized solar cell module 100, so as to protect the bottom and top surfaces of the dye-sensitized solar cell module 100. The second transparent substrate 128 includes a transparent substrate 122 and a conductive layer 126 formed on a top surface of the transparent substrate 122. The third transparent substrate 138 includes a transparent substrate 132 and a conductive layer 134 formed on the transparent substrate 132. Each of the transparent substrates 122 and 132 can be formed of glass, and each of the conductive layers 126 and 134 can be formed of ITO, FTO, or SnO₂. Alternatively, each of the transparent substrates 122 and 132 can be conductive transparent substrates formed of a conductive polymer. In this case, the conductive layers 126 and 134 are not required.

The first cell 140 is the lowest cell from among the first through fourth cells 140, 150, 160, and 170, and the semiconductor electrode 112a of the first cell 140 is formed on the conductive layer 126 of the second conductive transparent substrate 128. The fourth cell 170 is the highest cell from among the first through fourth cells 140, 150, 160, and 170, and the counter electrode 114d of the fourth cell 170 is formed on a bottom surface of the conductive layer 134 of the third conductive transparent substrate 138.

Each of the semiconductor electrodes 112a, 112b, 112c, and 112d of the first through fourth cells 140, 150, 160, and 170, respectively, can include a dye-adsorbed metal oxide layer. For example, the metal oxide layer can be formed of TiO₂, SnO₂, or ZnO to a thickness of about 3 µm to 12 µm. For example, the metal oxide layer may be formed of TiO₂ having a molecular size of about 15 to 25 nm. The dye absorbed in the metal oxide layer can be a ruthenium complex. The counter electrodes 114a, 114b, 114c, and 114d of the first through fourth cells 140, 150, 160, and 170, respectively, can be formed of platinum (Pt).

The electrolyte layers 116a, 116b, 116c, and 116d are formed between the semiconductor electrodes 112a, 112b, 112c, and 112d and the counter electrodes 114a, 114b, 114c, and 114d and are sealed by barrier walls 118a, 118b, 118c, and 118d, respectively. The electrolyte layers 116a, 116b, 116c, and 116d of the first through fourth cells 140, 150, 160, and 170, respectively, can be formed of an iodine based redox liquid electrolyte. For example, the electrolyte layers 116a, 116b, 116c, and 116d may be formed of an l₃⁻/l⁻ electrolyte solution prepared by dissolving 0.7 M of 1-vinyl-3-methyl-immidazolium iodide, 0.1 M of Lil, 40 mM of l₂ (iodine), and 0.2 M of tert-butyl pyridine into 3-methoxypropionitrile. The barrier walls 118a, 118b, 118c, and 118d of the first through fourth cells 140, 150, 160, and 170, respectively, can be formed of a thermoplastic high-polymer such as Surlyn. The barrier walls 118a, 118b, 118c, and 118d may be about 30 µm to 50 µm thick and about 1 mm to 4 mm wide.

Referring to FIG. 1, in the dye-sensitized solar cell module 100 having a vertically stacked cell structure, the first through fourth cells 140, 150, 160, and 170 are connected in series by a plurality of third conductive layers 180a, 180b, and 180c. The third conductive layers 180a, 180b, and 180c can be formed on sidewalls of the first conductive transparent substrates 108a, 108b, and 108c, respectively. In this case, the third conductive layers 180a, 180b, and 180c electrically connect the first conductive layers 104a, 104b, and 104c to the second conductive layers 106a, 106b, and 106c, respectively.

The third conductive layers 180a, 180b, and 180c can be formed by coating the sidewalls of the first conductive transparent substrates 108a, 108b, and 108c, respectively, with ITO, FTO, or SnO₂. Alternatively, the third conductive layers 180a, 180b, and 180c can be formed by coating the sidewalls of the first conductive transparent substrates 108a, 108b, and 108c, respectively, with a metal or a conductive polymer. In this case, the metal may be Ti, Cu, Al, or Zn, and the conductive polymer may be polyaniline.

Instead of the third conductive layers 180a, 180b, and 180c, other structures (not shown) can be used to connect the first through fourth cells 140, 150, 160, and 170 in series. For example, via contacts can be formed through the transparent substrates 102a, 102b, and 102c of the first conductive transparent substrates 108a, 108b, and 108c, respectively, so as to electrically connect the first conductive layers 104a, 104b, and 104c to the second conductive layers 106a, 106b, and 106c, respectively. Furthermore, connection lines (not shown) such as conductive wires can be used to electrically connect the first conductive layers 104a, 104b, and 104c to the second conductive layers 106a, 106b, and 106c, respectively.

As explained above, the transparent substrates 102a, 102b, and 102c can be formed of a conductive polymer, and the first conductive layers 104a, 104b, and 104c and the second conductive layers 106a, 106b, and 106c can be omitted. In this case, additional structures such as the third conductive layers 180a, 180b, and 180c are not required to electrically connect the first through fourth cells 140, 150, 160, and 170 in series.

An exemplary operation of the dye-sensitized solar cell module 100 of FIG. 1 will now be described according to an embodiment of the present invention.

Solar energy incident on the dye-sensitized solar cell module 100 is absorbed by dye molecules adsorbed in the metal oxide layer of the semiconductor electrode 112d of the fourth cell 170. Then, the dye molecules excite electrons into the conduction band of the metal oxide layer of the semiconductor electrode 112d of the fourth cell 170. The electrons move to the second conductive layer 106c of the first conductive transparent substrate 108c, which contacts the semiconductor electrode 112d through grain boundaries of the metal oxide layer of the semiconductor electrode 112d and further move to the counter electrode 114c of the third cell 160. As in the fourth cell 170, the electrons move from the counter electrode 114c of the third cell 160 to the second conductive layer 106b of the first conductive transparent substrate 108b through grain boundaries of the metal oxide layer of the semiconductor electrode 112c of the third cell 160 and further move to the counter electrode 114b of the second cell 150. In the same way, the electrons move to the first cell 140 through the semiconductor electrode 112b of the second cell 150 and the second conductive layer 106a of the first conductive transparent substrate108a. In the first cell 140, the electrons enter the metal oxide layer of the semiconductor electrode 112a of the first cell 140 and move to the second conductive transparent substrate 128 through grain boundaries of the metal oxide of the semiconductor electrode 112a of the first cell 140. Thereafter, the electrons move from the second conductive transparent substrate 128 to the counter electrode 114d of the fourth cell 170 formed on a lower surface of the third conductive transparent substrate 138 through an external connection wire (not shown).

The dye molecules that are oxidized by electron transfer across the semiconductor electrodes 112a, 112b, 112c, and 112d of the first through fourth cells 140, 150, 160, and 170, respectively, are reduced by receiving electrons from iodide ions of the electrolyte layers 116a, 116b, 116c, and 116d (3l⁻ > l⁻₃ + 2e⁻) of the first through fourth cells 140, 150, 160, and 170, respectively. The oxidized iodide ions 1-₃ are reduced by receiving electrons from the counter electrodes 114a, 114b, 114c, and 114d. In this way, the dye-sensitized solar cell module 100 operates.

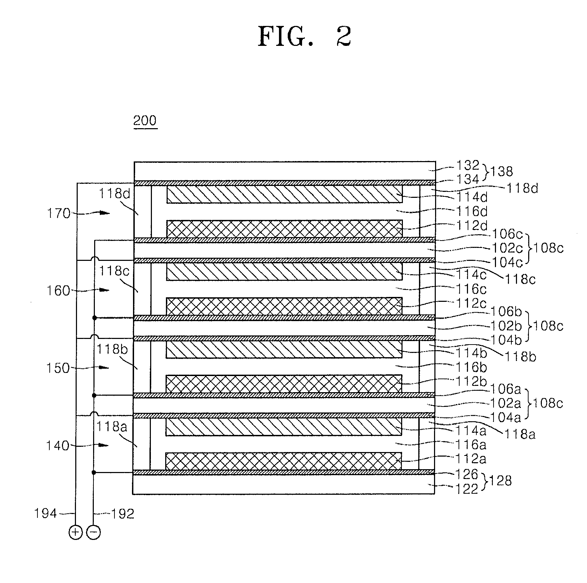

FIG. 2 is a schematic cross-sectional view illustrating a dye-sensitized solar cell module 200 having a vertically stacked cell structure according to another embodiment of the present invention.

The dye-sensitized solar cell module 200 of the current embodiment has a similar structure as the dye-sensitized solar cell module 100 illustrated in FIG. 1 except that first through fourth cells 140, 150, 160, and 170 of the dye-sensitized solar cell module 200 are connected in parallel to one another. In FIGS. 1 and 2, like reference numerals denote like elements. Thus, descriptions of the like elements will be omitted.

A first conductive line 192 can be used to connect semiconductor electrodes (negative electrodes) 112a, 112b, 112c, and 112d of the first through fourth cells 140, 150, 160, and 170, and a second conductive line 194 can be used to connect counter electrodes 114a, 114b, 114c, and 114d of the first through fourth cells 140, 150, 160, and 170, respectively, so as to connect the first through fourth cells 140, 150, 160, and 170 in parallel to one another.

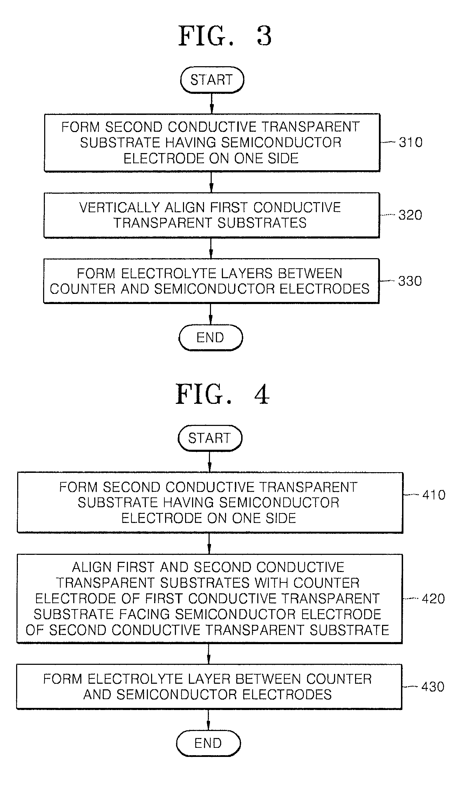

FIGS. 3 through 5 are flowcharts of methods of manufacturing a dye-sensitized solar cell module having a vertically stacked cell structure according to embodiments of the present invention.

Referring to FIG. 3, a plurality of first conductive transparent substrates 108a, 108b, and 108c are formed in operation 310. In the present embodiment, counter electrodes 114a, 114b, and 114c and semiconductor electrodes 112b, 112c, and 112d are formed on both sides of the first conductive transparent substrates 108a, 108b, and 108c.

In detail, first conductive layers 104a, 104b, and 104c and second conductive layers 106a, 106b, and 106c are formed on both sides of transparent substrates 102a, 102b, and 102c, respectively. When it is intended to connect the first through fourth cells 140, 150, 160, and 170 in series, conductive polymer substrates can be used as the transparent substrates 102a, 102b, and 102c of the first conductive transparent substrates 108a, 108b, and 108c, respectively. In this case, the first conductive layers 104a, 104b, and 104c and the second conductive layers 106a, 106b, and 106c may not formed.

Then, metal oxide layers are formed on the second conductive layers 106a, 106b, and 106c. For example, the metal oxide layers can be formed by depositing TiO₂ on the second conductive layers 106a, 106b, and 106c and heat treating the deposited TiO₂ at about 500°C. Then, the counter electrodes 114a, 114b, and 114c are formed on the first conductive layers 104a, 104b, and 104c. The counter electrodes 114a, 114b, and 114c can be formed by depositing Pt on the first conductive layers 104a, 104b, and 104c and heat treating the deposited Pt at about 400°C. Then, dye is applied to the metal oxide layers to chemically adsorb dye molecules to the metal oxide layers formed on the second conductive layers 106a, 106b, and 1 06c and form the semiconductor electrodes 112b, 112c, and 112d.

In operation 320, the first conductive transparent substrates 108a, 108b, and 108c are vertically aligned. As also shown in FIGS. 1 and 2, the first conductive transparent substrates 108a, 108b, and 108c are spaced apart from one another by barrier ribs 118b and 118c.

In operation 330, electrolyte layers 116b and 116c are formed by injecting liquid electrolyte between the first conductive transparent substrates 108a and 108b, i.e., between the semiconductor electrode 112b and the counter electrode 114b, and between the first conductive transparent substrates 108b and 108c, i.e., between the semiconductor electrode 112c and the counter electrode 114c, respectively. In this way, the first conductive transparent substrates 108a, 108b, and 108c are vertically stacked.

Referring to FIG. 4, in operation 410, a second conductive transparent substrate 128 having a semiconductor electrode 112a is formed. The semiconductor electrode 112a is formed on one surface of the second conductive transparent substrate 128. For example, the second conductive transparent substrate 128 can be formed in the same manner used for forming the first conductive transparent substrates 108a, 108b, and 108c in operation 310. However, in operation 410, a conductive layer 126 is formed only on one surface of a transparent substrate 122, and then the semiconductor electrode 112a is formed on the conductive layer 126, so as to form the second conductive transparent substrate 128. When a conductive high-polymer substrate is used as the transparent substrate 122 of the second conductive transparent substrate 128, the conductive layer 126 may not be formed. The semiconductor electrode 112a can be formed in the same manner used for forming the semiconductor electrodes 112b, 112c, and 112c in operation 310.

In operation 420, the second conductive transparent substrate 128 is aligned with the vertically stacked first conductive transparent substrates 108a, 108b, and 108c that are formed in operations 310 through 330. In the present embodiment, the semiconductor electrode 112a of the second conductive transparent substrate 128 faces the counter electrode 114a of the vertically stacked first conductive transparent substrate 108a. Furthermore, as also shown in FIGS. 1 and 2, a barrier wall 118a is interposed between the first conductive transparent substrate 108a and the second conductive transparent substrate 128.

In operation 430, liquid electrolyte is injected between the first conductive transparent substrate 108a and the second conductive transparent substrate 128, i.e., between the counter electrode 114a and the semiconductor electrode 112a, so as to form an electrolyte layer 116a.

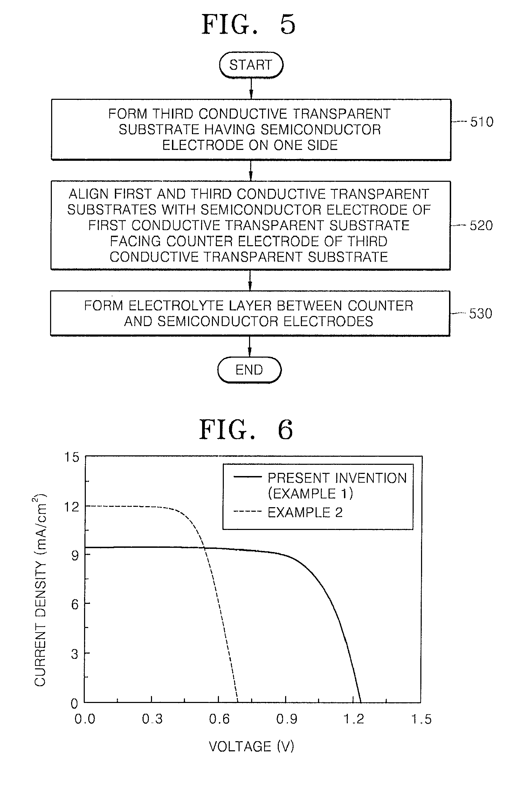

Referring to FIG. 5, in operation 510, a third conductive transparent substrate 138 having a counter electrode 114d is formed. The counter electrode 114d is formed on one surface of the third conductive transparent substrate 138. For example, the third conductive transparent substrate 138 can be formed in the same manner used for forming the first conductive transparent substrates 108a, 108b, and 108c in operation 310. However, in operation 510, a conductive layer 134 is formed only on one surface of a transparent substrate 132, and then the counter electrode 114d is formed on the conductive layer 134, so as to form the third conductive transparent substrate 138. When a conductive polymer substrate is used as the transparent substrate 132 of the third conductive transparent substrate 138, the conductive layer 134 may not be formed. The counter electrode 114d can be formed in the same manner used for forming the counter electrodes 114a, 114b, and 114c in operation 310.

In operation 520, the third conductive transparent substrate 138 is aligned with the vertically stacked first conductive transparent substrates 108a, 108b, and 108c as formed in operations 310 through 330. In the present embodiment, the counter electrode 114d of the third conductive transparent substrate 138 faces the semiconductor electrode 112d of the vertically stacked first conductive transparent substrates 108a, 108b, and 108c. Furthermore, as shown in FIGS. 1 and 2, a barrier wall 118d is interposed between the first conductive transparent substrate 108c and the third conductive transparent substrate 138.

In operation 530, liquid electrolyte is injected between the first conductive transparent substrate 108c and the third conductive transparent substrate 138, i.e., between the semiconductor electrode 112d and the counter electrode 114d, so as to form an electrolyte layer 116d.

Thereafter, third conductive layers 180a, 180b, and 180c can be formed as those shown in FIG. 1. Alternatively, first and second conductive lines 192 and 194 can be formed as those shown in FIG. 2.

In the method of manufacturing the dye-sensitized solar cell module having a vertically stacked cell structure according to the embodiments of FIGS. 3 through 5, after operations 310 through 330 of FIG. 3 are performed, operations 410 through 430 of FIG. 4 can be performed prior to or after operations 510 through 530 of FIG. 5.

### Example 1

### Manufacture of a dye-sensitized solar cell module having a vertically stacked cell structure

The dye-sensitized solar cell module having a vertically stacked cell structure was manufactured as test sample 1. This test sample 1 has the same structure as the dye-sensitized solar cell module 100 illustrated in FIG. 1 except that test sample 1 has only two cells that are vertically arranged.

In test sample 1, a first conductive transparent substrate was used and made by forming ITO layers on both sides of a glass substrate. A second conductive transparent substrate was made by forming an ITO layer on a side of a glass substrate, and a third conductive transparent substrate was made by forming an ITO layer on a side of a glass substrate. Hence, the ITO layers were formed on the glass substrates to a thickness of about 2000 Å by a sputtering method.

A TiO₂ layer was formed on one of the ITO layers of the first conductive transparent substrate and was heat treated at 500°C so as to remove impurities from the TiO₂ layer. Then, Pt was deposited on the other of the ITO layers of the first conductive transparent substrate and was heat treated at 400°C so as to form a counter electrode. Then, a ruthenium complex was adsorbed to the TiO₂ layer so as to form a semiconductor electrode. In the same manner, a semiconductor electrode was formed on the ITO layer of the second conductive transparent substrate, and a counter electrode was formed on the ITO layer of the third conductive transparent substrate. Then, the first, second, and third conductive transparent substrates each including a semiconductor electrode or a counter electrode were vertically aligned with high-polymer layers formed of Surlyn being interposed therebetween, so as to form a vertically stacked cell structure. Then, an l₃⁻/l⁻ electrolyte solution was injected between the first, second, and third conductive transparent substrates so as to form electrolyte layers. In test sample 1, the l₃⁻/l⁻ electrolyte solution was prepared by dissolving 0.7 M of 1-vinyl-3-methyl-immidazolium iodide, 0.1 M of Lil, 40 mM of l₂ (iodine), and 0.2 M of tert-butyl pyridine into 3-methoxypropionitrile. Then, titanium (Ti) was deposited on a sidewall of the first conductive transparent substrate by an e-beam deposition to a thickness of about 1000 Å so as to connect the ITO layers formed on both sides of the first conductive transparent substrate. In this way, a dye-sensitized solar cell module having two solar cells that are vertically stacked and electrically connected in series was made as test sample 1.

### Example 2

A dye-sensitized solar cell module having a single solar cell was made as test sample 2 by using the same second and third conductive transparent substrates as those made in Example 1.

### Example 3

### Energy conversion efficiency of a dye-sensitized solar cell module having a vertically stacked cell structure

The energy conversion efficiency of the dye-sensitized cell module of the present invention was evaluated by measuring, current density versus voltage (I-V) characteristics of test samples 1 and 2, and the measured results are shown in FIG. 6.

Referring to FIG. 6, the energy conversion efficiency of test sample 1 was 7.5%, and that of test sample 2 was 5.23%. Hence, according to the present invention, energy conversion efficiency can be increased by about 50%. In this case, power can be increased by 50% (power [W] = voltage x current). For the dye-sensitized solar cell module of the present invention, voltage increases to approximately double although current slightly decreases. Thus, the energy conversion efficiency of the dye-sensitized solar cell module can be improved.

As described above, the dye-sensitized solar cell module of the present invention includes a plurality of solar cells that are vertically arranged and one or more first conductive transparent substrates each interposed between two neighboring solar cells of the solar cells. Each of the first conductive transparent substrates includes a first surface on which a counter electrode of one of the two neighboring solar cells is formed and a second surface on which a semiconductor electrode of the other of the two neighboring solar cells is formed.

In the dye-sensitized solar cell module of the present invention, the solar cells can be connected in series without using an additional space that is required in a conventional solar cell module. Therefore, the dye-sensitized solar cell can have an increased energy conversion rate per unit area. Furthermore, the dye-sensitized solar cell module can be simply manufactured since the solar cells can be connected in series or in parallel with each other through a simple process.

According to the present invention, the dye-sensitized solar cell module having a vertically stacked cell structure can have a maximized effective area for absorbing solar energy and generating electrical energy. Furthermore, the dye-sensitized solar cell module having the vertically stacked cell structure can be manufactured through a simple process. Moreover, a desired open circuit voltage of the dye-sensitized solar cell module can be easily obtained since the number of stacked solar cells can be simply adjusted as required. In addition, dye-sensitized solar cell modules having different open circuit voltages can be manufactured using a single process line. Hence, dye-sensitized solar cell modules having different open circuit voltages can be efficiently manufactured at lower costs.

While the present invention has been particularly shown and described with reference to exemplary embodiments thereof, it will be understood by one of ordinary skill in the art that various changes in form and details may be made therein without departing from the spirit and scope of the present invention as defined by the following claims.

In summary an embodiment of the invention can be described as follows:

Provided are a dye-sensitized solar cell module having a vertically stacked cell structure and a method of manufacturing the same. In the dye-sensitized solar cell module, a plurality of cells are vertically stacked in parallel with each other. Each of the cells includes mutually facing semiconductor and counter electrodes and an electrolyte layer interposed between the semiconductor and counter electrodes. A first conductive transparent substrate is interposed between two neighboring cells of the cells. The first conductive transparent substrate includes a first surface on which the counter electrode of one of the two neighboring cells is formed and a second surface on which the semiconductor electrode of the other is formed. A second conductive transparent substrate having a semiconductor electrode forms the lowermost cell of the cells, and a third conductive transparent substrate having a counter electrode forms the uppermost cell of the cells.

## Claims

1. A dye-sensitized solar cell module with a vertically stacked cell structure, the dye-sensitized solar cell module comprising:
a plurality of cells vertically stacked in parallel with each other, each of the cells including mutually facing semiconductor electrode and counter electrode and an electrolyte layer interposed between the semiconductor electrode and counter electrode;
at least one of first conductive transparent substrate interposed between two neighboring first cell and second cell of the plurality of cells, the first conductive transparent substrates comprising a first surface on which the counter electrode of the first cell is formed and a second surface on which the semiconductor electrode of the second cell formed;
a second conductive transparent substrate comprising a third surface on which the semiconductor electrode of the lowermost cell of the plurality of cells is formed; and
a third conductive transparent substrate comprising a fourth surface on which the counter electrode of the uppermost cell of the plurality of cells is formed.

2. The dye-sensitized solar cell module of claim 1, wherein each of the first conductive transparent substrates further comprises:
a transparent substrate; and
first and second conductive layers formed on both sides of the transparent substrate.

3. The dye-sensitized solar cell module of claim 2, wherein the transparent substrate is a glass substrate, and the first and second conductive layers are formed of ITO (indium tin oxide), FTO (fluorine-doped tin oxide), or SnO₂,

4. The dye-sensitized solar cell module of any of the preceding claims, wherein each of the first conductive transparent substrates is formed of a conductive polymer.

5. The dye-sensitized solar cell module of any of the preceding claims, wherein only one of the first conductive transparent substrate is disposed between the second and third conductive transparent substrates.

6. The dye-sensitized solar cell module of any of claims 1 to 4, wherein a plurality of the first conductive transparent substrates is disposed between the second and third conductive transparent substrates.

7. The dye-sensitized solar cell module of any of the preceding claims, wherein the second conductive transparent substrate is formed of a transparent substrate having a conductive layer only on an upper or lower surface of the transparent substrate, and the third conductive transparent substrate is formed of a transparent substrate having a conductive layer only on a lower or upper surface of the transparent substrate.

8. The dye-sensitized solar cell module of any of the preceding claims, wherein the second and third conductive transparent substrates are formed of a conductive polymer.

9. The dye-sensitized solar cell module of any of the preceding claims, wherein the semiconductor electrodes are formed of a metal oxide layer to which dye molecules are adsorbed.

10. The dye-sensitized solar cell module of claim 9, wherein the metal oxide layer is formed of at least one material selected from the group consisting of TiO₂, SnO₂, and ZnO.

11. The dye-sensitized solar cell module of any of the preceding claims, wherein the counter electrodes are formed of Pt.

12. The dye-sensitized solar cell module of any of the preceding claims, wherein the electrolyte layer are formed of an iodine based redox liquid electrolyte.

13. The dye-sensitized solar cell module of any of the preceding claims, wherein the cells are connected in series.

14. The dye-sensitized solar cell module of any of claims 1 to 12, wherein the cells are connected in parallel with each other.

15. The dye-sensitized solar cell module of claim 2, wherein the first conductive transparent substrate further comprises a third conductive layer electrically connecting the first and second conductive layers, and the two neighboring cells are connected in series by the third conductive layer.

16. The dye-sensitized solar cell module of claim 15, wherein the third conductive layer is formed on a sidewall of the first conductive transparent substrate.

17. The dye-sensitized solar cell module of claim 15 or 16, wherein the third conductive layer is formed of at least one material selected from the group consisting of ITO, FTO, SnO₂, metal, and a conductive polymer.

18. A method of manufacturing a dye-sensitized solar cell module having a vertically stacked cell structure, the method comprising:
forming a first conductive transparent substrate including a first surface on which a first counter electrode is formed and a second surface on which a first semiconductor electrode is formed;
forming a second conductive transparent substrate including a third surface on which a second semiconductor electrode is formed;
aligning the first and second conductive transparent substrates with the first counter electrode facing the second semiconductor electrode, the first counter electrode spaced by a first predetermined distance apart from the second semiconductor electrode; and
injecting an electrolyte solution between the first counter electrode and the second semiconductor electrode so as to form a first electrolyte layer.

19. The method of claim 18, wherein the aligning of the first and second conductive transparent substrates comprises forming a barrier wall between the first and second conductive transparent substrates so as to seal a space between the first counter electrode and the second semiconductor electrode.

20. The method of claim 18 or 19, further comprising:
forming a third conductive transparent substrate including a fourth surface on which a second counter electrode is formed;
aligning the first and third conductive transparent substrates with the first semiconductor electrode facing the second counter electrode, the first semiconductor electrode spaced by a second predetermined distance apart from the second counter electrode; and
injecting an electrolyte solution between the first semiconductor electrode and the second counter electrode so as to form a second electrolyte layer.

21. The method of claim 20, wherein the aligning of the first and third conductive transparent substrates comprises forming a barrier wall between the first and third conductive transparent substrates so as to seal a space between the first semiconductor electrode and the second counter electrode.

22. The method of any of claims 18 to 21, further comprising:
forming a plurality of first conductive transparent substrates;
vertically aligning the first conductive transparent substrates, the first conductive transparent substrates being parallel with each other and spaced by a predetermined distance apart from each other; and
injecting an electrolyte solution between the first conductive transparent substrates so as to form electrolyte layers.
